(19) Europäisches Patentamt
European Patent Office
Office européen des brevets

(11) **EP 2 309 540 A1**

(12) **EUROPÄISCHE PATENTANMELDUNG**

(43) Veröffentlichungstag:
**13.04.2011 Patentblatt 2011/15**

(51) Int Cl.:
**H01L 27/142** *(2006.01)*  **H01L 31/042** *(2006.01)*

(21) Anmeldenummer: **09172782.6**

(22) Anmeldetag: **12.10.2009**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**AL BA RS**

(71) Anmelder: **Inventux Technologies AG**
**12681 Berlin (DE)**

(72) Erfinder:
• **Stanzel, Jörg**
  **10245 Berlin (DE)**
• **Papathanasiou, Niklas**
  **10405 Berlin (DE)**

(74) Vertreter: **Grünecker, Kinkeldey,**
**Stockmair & Schwanhäusser**
**Anwaltssozietät**
**Leopoldstrasse 4**
**80802 München (DE)**

(54) **Photovoltaik-Modul**

(57) Die Erfindung betrifft ein Photovoltaik-Modul, insbesondere ein Dünnschicht-Photovoltaik-Modul, umfassend mehrere in Reihe geschaltete Zellen, wobei wenigstens zwei der Zellen voneinander unterschiedlich große Flächen aufweisen, sowie ein Verfahren zum Herstellen von Photovoltaik-Modulen mit mehreren in Reihe geschalteten Zellen, umfassend die Schritte: a) Bestimmen einer Verteilung wenigstens eines Parameterwertes über die Fläche eines Testmoduls; b) Bestimmen angepasster Zellflächengrößen, insbesondere angepasster Zellbreiten, basierend auf der Verteilung des wenigstens einen Parameterwertes über die Fläche des Testmoduls; und c) Herstellen wenigstens eines Photovoltaik-Moduls mit Zellen mit der angepassten Zellflächengröße, insbesondere angepasster Zellbreite. Dadurch wird es möglich über die Moduloberfläche verteilte Inhomogenitäten in Zellparameterwerten zu kompensieren, sodass die Stromausbeute optimiert wird.

EP 2 309 540 A1

FIG. 3

**Beschreibung**

Die Erfindung betrifft ein Photovoltaik-Modul, insbesondere ein Dünnschicht-Photovoltaik-Modul, umfassend mehrere in Reihe geschaltete Zellen.

Photovoltaik-Module, insbesondere solche basierend auf Dünnschichttechnologien, werden meist in mehrere parallel zueinander angeordnete Zellen unterteilt. Diese sogenannte monolitische Verschaltung führt zu einer Reihenschaltung der Zellen. Durch die Erhöhung der Zellanzahl erhöht sich die Modulspannung aufgrund der Aufsummierung der Spannung der einzelnen Zellen. Dadurch können Leistung und Wirkungsgrad des Moduls insgesamt verbessert werden.

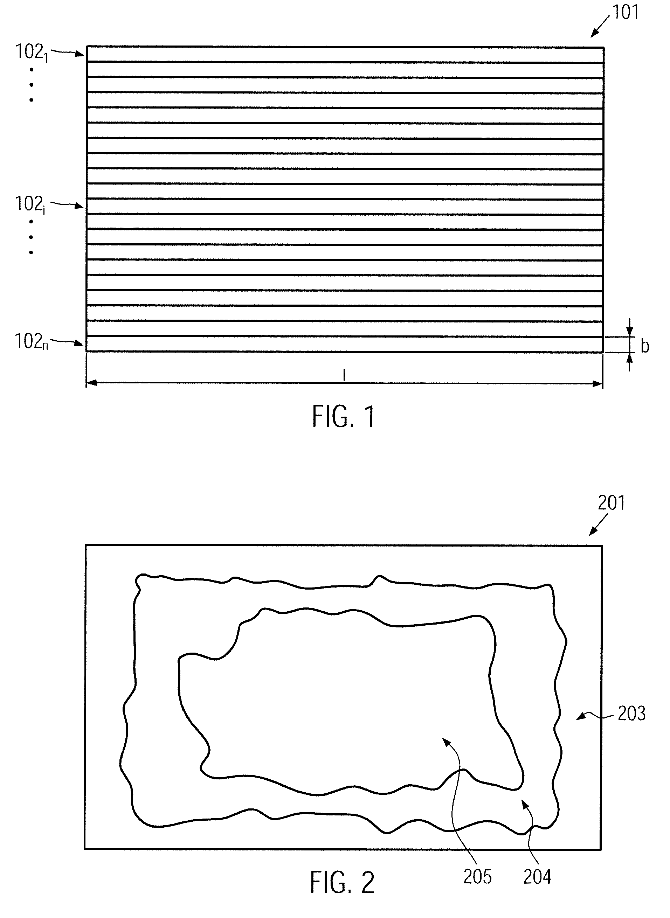

Figur 1 zeigt eine Draufsicht auf ein herkömmliches Photovoltaik-Modul 101, wie im Stand der Technik bekannt. Derartige Module umfassen mehrere in Reihe geschaltete Zellen 102i, welche alle die gleiche Fläche aufweisen. Typischerweise haben die Zellen 102i, wie in Figur 1, eine rechteckige Form und weisen alle die gleiche Länge l und die gleiche Breite b auf. Eine Zelle umfasst üblicherweise eine durchsichtige Frontkontaktschicht, beispielsweise eine TCO Schicht, eine Absorberschicht bzw. aktive Schicht in der das einfallende Licht in Ladungsträger umgewandelt wird, und eine Rückkontaktschicht, beispielsweise ebenfalls eine TCO Schicht.

Es hat sich jedoch herausgestellt, dass die von einem derartigen Photovoltaik-Modul gelieferte Gesamtstromstärke häufig nicht der theoretisch erwarteten Stromstärke entspricht. Insbesondere erweist sich die Gesamtstromstärke des Photovoltaik-Moduls üblicherweise als geringer als erwartet.

Es ist folglich die Aufgabe der vorliegenden Erfindung, ein Photovoltaik-Modul bereitzustellen, bei dem die Leistung des Moduls optimiert wird. Diese Aufgabe wird durch ein Photovoltaik-Modul gemäß Anspruch 1 gelöst.

Die Erfindung stellt ein Photovoltaik-Modul, insbesondere ein Dünnschicht-Photovoltaik-Modul, bereit, umfassend mehrere in Reihe geschaltete Zellen, wobei wenigstens zwei der Zellen voneinander unterschiedlich große Flächen aufweisen.

Es hat sich herausgestellt, dass es, insbesondere bei dünnschichtbasierten Photovoltaik-Modulen, zu, insbesondere lateralen, Inhomogenitäten in einer oder mehreren Schichteigenschaften kommen kann. Diese Inhomogenitäten können zu unterschiedlichen Strömen in unterschiedlichen Bereichen des Photovoltaik-Moduls führen. Je nach deren Position auf dem Photovoltaik-Modul können daher unterschiedliche Zellen unterschiedliche Ströme liefern. Da in einer Reihenverschaltung die Zelle mit dem geringsten Strom den Gesamtstrom bestimmt, kommt es bei den bekannten Modulen häufig zu der beobachteten Abweichung der Gesamtstromstärke vom theoretisch erwarteten Wert.

Die unterschiedlich große Fläche der wenigstens zwei Zellen eines erfindungsgemäßen Photovoltaik-Moduls erlaubt es, die Variationen des von den Zellen gelieferten Stromes zu minimieren. Dadurch kann der Gesamtstrom und damit die Leistung des Moduls optimiert, insbesondere erhöht, werden.

Hier versteht man unter dem Begriff Zellen lediglich solche Bereiche des Photovoltaik-Moduls, die zur Stromproduktion des Photovoltaik-Moduls beitragen. Insbesondere versteht man darunter nicht solche Bereiche, die lediglich dazu dienen, den Strom von einer Frontkontaktschicht zu einer Rückkontaktschicht zu führen.

Die Zellen können nebeneinander, insbesondere parallel zueinander, in einer Ebene angeordnet sein, also eine Zellebene bilden. Die Fläche einer Zelle kann in der Zellebene angeordnet sein. Mit anderen Worten kann die Fläche einer Zelle der Ausdehnung der Zelle in der Zellebene entsprechen während die Dicke einer Zelle der Ausdehnung einer Zelle senkrecht zur Zellebene entspricht.

Die Fläche einer Zelle kann auch in einer zur Zellebene parallelen Ebene angeordnet sein. Das Photovoltaik-Modul kann insbesondere eine Schar von zur Zellebene parallelen Ebenen aufweisen. Die äußerste Ebene der Schar von Ebenen, die im Betrieb des Photovoltaik-Moduls der Lichtquelle, insbesondere der Sonne, zugewandt ist, kann als Lichteinfallsebene bezeichnet werden. Durch die Lichteinfallsebene kann Licht in das Photovoltaik-Modul eintreten. Die Fläche einer Zelle kann in der Lichteinfallsebene angeordnet sein.

Die Fläche einer Zelle kann insbesondere eine im Betrieb des Photovoltaik-Moduls einer Lichtquelle, insbesondere der Sonne, zugewandte Fläche sein. Insbesondere kann die Fläche in einer Ebene angeordnet sein, welche senkrecht zur Stromrichtung in der Zelle angeordnet ist.

Das Photovoltaik-Modul, insbesondere die Zellen des Photovoltaik-Moduls, können mehrere parallele Schichten umfassen, welche insbesondere parallel zur Zellebene angeordnet sind. Die Fläche einer Zelle kann der Fläche einer der parallelen Schichten der Zelle entsprechen.

Bevorzugt können die wenigstens zwei Zellen, insbesondere die Fläche der wenigstens zwei Zellen, im Wesentlichen rechteckig ausgebildet sein und die wenigstens zwei Zellen können die gleiche Länge aber voneinander unterschiedliche Breiten aufweisen. Dadurch kann die Herstellung eines Photovoltaik-Moduls mit Zellen unterschiedlicher Zellflächengröße vereinfacht werden.

Alternativ können die wenigstens zwei Zellen, insbesondere die Fläche der wenigstens zwei Zellen, auch eine beliebige andere Form oder Geometrie aufweisen.

Die Größe der Fläche, insbesondere die Breite, der wenigstens zwei Zellen kann so angepasst sein, dass die wenigstens zwei Zellen im Wesentlichen die gleiche Stromstärke oder zumindest eine um nicht mehr als 5%, insbesondere nicht mehr als 1%, bevorzugt nicht mehr als 0,2%, variierende Stromstärke liefern. Dadurch kann der von dem Photovoltaik-Modul gelieferte Gesamtstrom optimiert werden.

Es können insbesondere alle der in Reihe geschalteten Zellen voneinander unterschiedlich große Flächen aufweisen. Es können alle in Reihe geschalteten Zellen rechteckig ausgebildet sein, wobei die Zellen die gleiche Länge aber voneinander unterschiedliche Breiten aufweisen.

Insbesondere kann die Größe der Fläche, insbesondere die Breite, aller in Reihe geschalteter Zellen so angepasst sein, dass alle in Reihe geschaltete Zellen im Wesentlichen die gleich Stromstärke oder zumindest eine um nicht mehr als 5 %, insbesondere nicht mehr als 1 %, bevorzugt nicht mehr als 0,2 %, variierende Stromstärke liefern.

Die Größe der Fläche, insbesondere die Breite, der wenigstens zwei Zellen kann basierend auf wenigstens einem Parameterwert der Zelle angepasst sein. Mit anderen Worten kann wenigstens ein Parameterwert, also der Wert wenigstens eines Parameters, der Zelle verwendet worden sein, um die Größe der Fläche, insbesondere die Breite, der wenigstens zwei Zellen anzupassen. In diesem Fall kann eine Relation, insbesondere eine lineare oder indirekt proportionale Relation, zwischen der Größe der Fläche, insbesondere der Breite, der wenigstens zwei Zellen und dem wenigstens einen Parameterwert der jeweiligen Zelle bestehen.

Der wenigstens eine Parameter kann einer Kurzschlussstromdichte und/oder einer Schichtdicke, insbesondere einer aktiven Schicht, und/oder einer Leitfähigkeit, insbesondere einer Frontkontaktschicht, und/oder einer Dotierung, insbesondere einer Frontkontaktschicht, und/oder einer Kristallinität, insbesondere einer aktiven Schicht, und/oder einem Haze Parameter, insbesondere einer Frontkontaktschicht, entsprechen.

Der wenigstens eine Parameterwert kann insbesondere einem Mittelwert einer Kurzschlussstromdichte und/oder einer Schichtdicke, insbesondere einer aktiven Schicht, und/oder einer Leitfähigkeit, insbesondere einer Frontkontaktschicht, und/oder einer Dotierung, insbesondere einer Frontkontaktschicht, und/oder einer Kristallinität, insbesondere einer aktiven Schicht, und/oder eines Haze Parameters, insbesondere einer Frontkontaktschicht, entsprechen.

Die Kurzschlussstromdichte entspricht dem Strom, den eine Solarzelle erzeugt, wenn keine Spannung abgegriffen wird, normiert auf eine Einheitsfläche, üblicherweise auf einen Quadratzentimeter. Der Haze Parameter entspricht dem Verhältnis von diffus transmittiertem Licht zu total transmittiertem Licht. Je höher der Haze Parameter der Frontkontaktschicht ist, umso besser kann Licht in eine Zelle eines Photovoltaik-Moduls eingekoppelt werden.

Die Größe der Fläche, insbesondere die Breite, aller in Reihe geschalteter Zellen kann basierend auf wenigstens einem Parameterwert der jeweiligen Zelle angepasst sein, wobei insbesondere der wenigstens eine Parameter einer Kurzschlussstromdichte und/oder einer Schichtdicke, insbesondere einer aktiven Schicht, und/oder Leitfähigkeit, insbesondere einer Frontkontaktschicht, und/oder einer Dotierung, insbesondere einer Frontkontaktschicht, und/oder einer Kristallinität, insbesondere einer aktiven Schicht, und/oder einem Haze Parameter, insbesondere einer Frontkontaktschicht, entsprechen kann.

Die in Reihe geschalteten Zellen können eine oder mehrere zwischen einer Front- und Rückkontaktschicht angeordnete Absorberschichten oder aktive Schichten aufweisen. Die eine oder mehreren Absorberschichten können eine oder mehrere Teilschichten umfassen, wobei insbesondere eine Teilschicht amorphes und/oder mikrokristallines Silizium und/oder $Si_x Ge_{1-x}$ (Siliziumgermanium) und/oder $Si_x C_{1-x}$ (Siliziumcarbid) umfassen kann, wobei x im Bereich 0 bis 1 liegt. Hierbei können insbesondere die verwendeten Materialien üblicherweise zusätzlich Wasserstoff dotiert sein. Mit anderen Worten kann eine Absorberschicht einer Multi-Junction Schicht, beispielsweise einer Tandemschicht, entsprechen. Eine oder mehrere Absorberschichten können beispielsweise eine p-dotierte, eine intrinsische und eine n-dotierten Schicht (pin oder nip Struktur) aus amorphen und/oder mikrokristallinen Silizium umfassen.

Das Photovoltaik-Modul kann ferner ein Vorder- und/oder Rückglas aufweisen, wobei insbesondere zwischen dem Vorderglas und der Rückkontaktschicht eine reflektierende Schicht angeordnet ist.

Das Photovoltaik-Modul kann außerdem wenigstens zwei parallel verschaltete Bereiche aufweisen. Dadurch wird es möglich ein Photovoltaik-Modul mit der gewünschten Ausgangsspannung herzustellen. Insbesondere kann die Front- und Rückkontaktschicht und die dazwischen angeordnete Absorberschicht so strukturiert sein, dass in einem Bereich mehrere seriell geschaltete Zellen gebildet werden.

Das Photovoltaik-Modul kann wenigstens zwei entlang einer ersten Richtung voneinander isolierte Bereiche aufweisen, die parallel verschaltet sind, wobei die wenigstens zwei parallel verschalteten Bereiche mehrere in Reihe geschaltete Zellen aufweisen und wobei wenigstens eine Zelle eines Bereiches in der ersten Richtung eine von wenigstens einer Zelle eines anderen Bereiches unterschiedliche Längenausdehnung aufweist.

Insbesondere kann eine Zelle eines Bereiches eine Längenausdehnung in einer ersten und in einer zweiten Richtung aufweisen. Die erste Richtung kann insbesondere der Richtung entsprechen, entlang derer die wenigstens zwei Bereiche voneinander isoliert sind. Die zweite Richtung kann senkrecht zur ersten Richtung verlaufen.

Die Erfindung stellt außerdem ein Verfahren zum Herstellen von Photovoltaik-Modulen mit mehreren in Reihe geschalteten Zellen, insbesondere von oben beschriebenen Photovoltaik-Modulen, bereit, umfassend die Schritte:

a) Bestimmen einer Verteilung wenigstens eines Parameterwertes über die Fläche eines Testmoduls,

b) Bestimmen angepasster Zellflächengrößen, insbesondere angepasster Zellbreiten, basierend auf der Verteilung des wenigstens einen Parameterwertes über die Fläche des Testmoduls, und

c) Herstellen wenigstens eines Photovoltaik-Moduls mit Zellen mit der angepassten Zellflächengröße, insbesondere angepasster Zellbreite.

Das Verfahren ermöglicht die Herstellung von Photovoltaik-Modulen mit adaptiven Zellflächengrößen. Die angepassten Zellflächengrößen, insbesondere die angepassten Zellbreiten, können derart bestimmt werden, dass die in Reihe geschalteten Zellen im Wesentlichen die gleiche Stromstärke oder zumindest eine um nicht mehr als 5 %, insbesondere nicht mehr als 1 %, bevorzugt nicht mehr als 0,2 %, variierende Stromstärke liefern. Dadurch können Photovoltaik-Module mit optimierter Leistung, insbesondere mit optimiertem Gesamtstrom, erzeugt werden.

Schritt c) kann insbesondere ein Unterteilen des Photovoltaik-Moduls mit Hilfe eines Laserablationsverfahrens in mehrere Zellen umfassen, wobei das Photovoltaik-Modul derart unterteilt wird, dass die Zellen die angepasste Zellflächengröße aufweisen. Die angepasste Zellflächengröße, insbesondere die angepasste Zellbreite, kann insbesondere für wenigstens zwei der Zellen voneinander unterschiedlich sein.

Das Bestimmen angepasster Zellflächengrößen, insbesondere angepasster Zellbreiten, kann insbesondere derart durchgeführt werden, dass die Gesamtanzahl der Zellen des Photovoltaik-Moduls konstant gehalten wird.

Der wenigstens eine Parameter kann einer Kurzschlussstromdichte und/oder einer Schichtdicke, insbesondere der aktiven Schicht, und/oder einer Leitfähigkeit, insbesondere der Frontkontaktschicht, und/oder einer Dotierung, insbesondere der Frontkontaktschicht, und/oder einer Kristallinität, insbesondere der aktiven Schicht, und/oder einem Haze Parameter, insbesondere der Frontkontaktschicht, entsprechen. Der wenigstens eine Parameterwert kann insbesondere ein Mittelwert über die Zellflächengröße sein. Die angepasste Zellflächengröße, insbesondere die angepasste Zellbreite, einer Zelle des Photovoltaik-Moduls kann basierend auf einer Relation, insbesondere basierend auf einer linearen oder indirekt proportionalen Relation, zwischen einem Parameterwert oder einem Mittelwert eines Parameterwertes und der Zellflächengröße, insbesondere der Zellbreite, bestimmt werden.

Schritt b) kann insbesondere für das gesamte Photovoltaik-Modul, insbesondere für alle in Reihe geschalteten Zellen, durchgeführt werden. Alternativ kann Schritt b) nur für einen oder mehrere vorherbestimmte Bereiche durchgeführt werden, insbesondere für Zellen, die in dem einen oder mehreren vorherbestimmten Bereichen angeordnet werden.

So kann das Photovoltaik-Modul wenigstens einen Bereich aufweisen, in dem wenigstens ein Parameterwert derart vom Mittelwert des Parameterwertes über die Gesamtfläche des Photovoltaik-Moduls abweicht, dass der von dem wenigstens einen Bereich gelieferte Strom geringer ist als der im Mittel vom Photovoltaik-Modul gelieferte Strom. Der wenigstens eine Bereich kann insbesondere einem Randbereich des Photovoltaik-Moduls entsprechen oder einen Randbereich des Photovoltaik-Moduls umfassen. Schritt b) kann insbesondere nur für Zellen in diesem wenigstens einen Bereich durchgeführt werden.

Als Randbereich kann ein, insbesondere umlaufender, Bereich des Photovoltaik-Moduls in der Zellebene bezeichnet werden, der das Photovoltaik-Modul nach außen begrenzt. Der Randbereich kann insbesondere eine Fläche von mehr als einem Zehntel und weniger als einem Viertel, insbesondere mehr als einem Fünftel und weniger als einem Viertel, der Gesamtfläche des Photovoltaik-Moduls aufweisen. Der Randbereich kann insbesondere eine Breite aufweisen, die kleiner als 100 mm und größer als 5 mm ist. Nicht unter diesen Randbereich fallen soll der so genannte randentschichtete Bereich des Photovoltaik-Moduls, der das Photovoltaik-Modul zur Umgebung hin isoliert. Im randentschichteten Bereich werden über eine Breite von bis zu ca. 20mm die Front- und Rückkontaktschicht sowie der aktive Bereich entfernt.

Im Randbereich können Parameterwertabweichungen auftreten, die im Mittel größer sind als in Innenbereichen des Photovoltaik-Moduls. Diesen Parameterwertabweichungen kann durch Bestimmen angepasster Zellflächengrößen, insbesondere angepasster Zellbreiten, insbesondere im Randbereich, Rechnung getragen werden.

Das Herstellen des wenigstens einen Photovoltaik-Moduls kann in einem ersten Herstellungsschritt eine Deposition einer oder mehrerer Schichten auf einem Substrat, beispielsweise aus Glas, umfassen. Insbesondere kann eine Front- und Rückkontaktschicht und wenigstens eine zwischen Front- und Rückkontaktschicht angeordnete Absorberschicht vorgesehen werden, wobei insbesondere die Absorberschicht eine amorphe und/oder eine mikrokristalline Siliziumschicht aufweisen kann. Die Absorberschicht kann beispielsweise eine p-dotierte, eine intrinsische und eine n-dotierte Schicht (pin oder nip Struktur) aus amorphen und/oder aus mikrokristallinen Silizium umfassen. Das Substrat kann insbesondere einem Vorder- und/oder Rückglas entsprechen.

Weiter kann das Herstellen des wenigstens einen Photovoltaik-Moduls ein Strukturieren oder Unterteilen des Photovoltaik-Moduls in mehrere in Reihe geschaltete Zellen umfassen. Bevorzugt kann das Strukturieren durch Laserablation, Scribing (mechanisches Ritzen) oder Lithographie erfolgen.

Das Testmodul kann dem Photovoltaik-Modul selbst entsprechen. Alternativ kann das Testmodul ein individuelles Testmodul sein, dessen Herstellung den gleichen ersten Herstellungsschritt wie das Photovoltaik-Modul umfasst. Mit anderen Worten kann die Herstellung des Testmoduls eine Deposition oder Abscheidung einer oder mehrerer Schichten auf einem Substrat, beispielsweise aus Glas, umfassen. Die Deposition der einen oder mehreren Schichten kann mit dem gleichen Verfahren, insbesondere mit derselben Vorrichtung, durchgeführt werden wie für das Photovoltaik-Modul.

Die Schritte a) und b) können nach einer vorherbestimmten Anzahl von in Schritt c) hergestellten Photovoltaik-Modulen wiederholt werden. Dadurch kann einer eventuellen Änderung der Verteilung der, insbesondere lateralen, Inhomogenitäten auf den Photovoltaikmodulen und der damit einhergehenden Änderung der Verteilung des wenigstens einen Parameterwertes, beispielsweise durch Änderungen von Prozessparametern, Rechnung getragen werden. Eine solche Änderung kann sich durch Schwankungen der Prozessparameter, einen Drift in den Anlagen oder Ähnliches ergeben.

Alternativ oder zusätzlich können die Schritte a) und b) wiederholt werden, wenn die Prozessparameter geändert werden. Dies kann insbesondere der Fall sein, wenn ein geändertes oder unterschiedliches Photovoltaik-Modul hergestellt werden soll.

Das Testmodul kann über dessen Fläche verteilt eine Vielzahl von individuellen Testzellen aufweisen. Durch die individuellen Testzellen kann der wenigstens eine Parameterwert an einer Vielzahl von individuellen Stellen des Testmoduls unabhängig von den anderen Testzellen bestimmt oder vermessen werden, und daraus die Verteilung des wenigstens einen Parameterwertes über die Fläche des Testmoduls bestimmt werden.

Die individuellen Testzellen können regelmäßig, insbesondere in gleichen Abständen, über die Fläche des Testmoduls verteilt sein.

Alternativ können die individuellen Testzellen inhomogen über die Fläche des Testmoduls verteilt sein, insbesondere wobei der Randbereich des Testmoduls eine höhere Anzahl an Testzellen aufweisen kann als ein innerer Bereich des Testmoduls. Inhomgenitäten treten verstärkt am Rand eines Moduls auf, daher kann man in diesem kritischen Bereich durch das Bereitstellen einer erhöhten Anzahl, die Flächenanpassung der Zellen noch weiter verbessern.

Die Testzellen können prinzipiell eine beliebige Form oder Geometrie und/oder Größe aufweisen. Insbesondere können die Testzellen quadratisch oder rechteckig ausgebildet sein.

Alternativ oder zusätzlich zum Bestimmen einer Verteilung wenigstens eines Parameterwertes über die Fläche eines Testmoduls durch Messung an einer oder mehreren Testzellen kann die Verteilung des wenigstens einen Parameterwertes über die Fläche des Testmoduls auch durch Simulation auf Basis eines oder mehrere Prozessparameter erfolgen.

Die Erfindung stellt außerdem ein Verfahren zum Herstellen von Photovoltaik-Modulen mit mehreren in Reihe geschalteten Zellen, insbesondere von oben beschriebenen Photovoltaik-Modulen, bereit, umfassend:

Herstellen wenigstens eines Photovoltaik-Moduls mit Zellen mit angepasster Zellflächengröße, insbesondere angepasster Zellbreite, mit den Schritten

Bestimmen einer Verteilung wenigstens eines Parameterwertes über die Fläche des wenigstens einen Photovoltaik-Moduls basierend auf einer Messung des wenigstens einen Parameterwertes an wenigstens einer Stelle des wenigstens einen Photovoltaik-Moduls, und

Bestimmen angepasster Zellflächengrößen, insbesondere angepasster Zellbreiten, basierend auf der Verteilung des wenigstens einen Parameterwertes über die Fläche des wenigstens einen Photovoltaik-Moduls.

In diesem Fall können die angepassten Zellflächengrößen, insbesondere die angepassten Zellbreiten, im Herstellungsprozess, insbesondere auch ohne Verwendung eines eigenen Testmoduls, bestimmt werden.

Das Bestimmen einer Verteilung wenigstens eines Parameterwertes und das Bestimmen angepasster Zellflächengrößen kann insbesondere vor dem Strukturieren oder Unterteilen des wenigstens einen Photovoltaik-Moduls in mehrere in Reihe geschaltete Zellen aber nach der Bildung aller Schichten des wenigstens einen Photovoltaik-Moduls erfolgen.

Das Bestimmen einer Verteilung wenigstens eines Parameterwertes kann hier insbesondere ein Messen des wenigstens einen Parameterwertes an wenigstens einer, insbesondere nur einer, Stelle des Photovoltaik-Moduls und Bestimmen der Verteilung des wenigstens einen Parameterwertes über die Fläche des wenigstens einen Photovoltaik-Moduls basierend auf der Messung mittels Simulation oder Extrapolation umfassen.

Insbesondere kann ein bekannter, insbesondere empirischer oder theoretischer, Zusammenhang zwischen dem wenigstens einen Parameterwert an der wenigstens einen Stelle des wenigstens einen Photovoltaik-Moduls und der Verteilung des wenigstens einen Parameterwertes über die Fläche des wenigstens einen Photovoltaik-Moduls bestehen. In diesem Fall kann die Verteilung des wenigstens einen Parameterwertes über die Fläche des wenigstens einen Photovoltaik-Moduls basierend auf dem bekannten, insbesondere empirischen oder theoretischen, Zusammenhang und der Messung des wenigstens einen Parameterwertes an der wenigstens einen Stelle des wenigstens einen Photovoltaik-Moduls bestimmt werden.

Diese Bestimmung kann rechnerisch, insbesondere mit Hilfe eines Computers, durchgeführt werden.

Die Erfindung stellt außerdem ein Testmodul bereit, insbesondere zum Verwenden in einem oben beschriebenen Verfahren, wobei das Testmodul über dessen Fläche verteilt eine Vielzahl von individuellen Testzellen aufweist. Mit Hilfe eines solchen Testmoduls lässt sich die Verteilung wenigstens eines Parameterwertes auf einfache Weise feststellen. Das Testmodul kann insbesondere eines oder mehrere der oben beschriebenen Merkmale aufweisen. Eine Vielzahl von Testzellen kann insbesondere zwei oder mehr Testzellen entsprechen.

Nachfolgend wird die Erfindung anhand von erfindungsgemäßen Beispielen und der Figu ren näher beschrieben. Dabei zeigt

Figur 1    eine Draufsicht auf ein aus dem Stand der Technik bekanntes Photovoltaik- Modul;

Figur 2    eine schematische Darstellung der lateralen Inhomogenitäten eines beispiel- haften Moduls;

Figur 3    eine Draufsicht auf ein erfindungsgemäßes Photovoltaik-Modul mit Zellen, die voneinander unterschiedlich große Flächen aufweisen;

Figur 4    ein weiteres erfindungsgemäßes Photovoltaik-Modul umfassend zwei parallel verschaltete, voneinander isolierte Bereiche;

Figur 5    ein Beispiel eines erfindungsgemäßen Testmoduls mit darauf angeordneten Testzellen;

Figur 6    eine Illustration eines Verfahrens zum Herstellen von Photovoltaik-Modulen entsprechend der Erfindung in Form eines Flussdiagramms; und

Figur 7    eine Illustration eines weiteren Verfahrens zum Herstellen von Photovoltaik- Modulen entsprechend der Erfindung in Form eines Flussdiagramms.

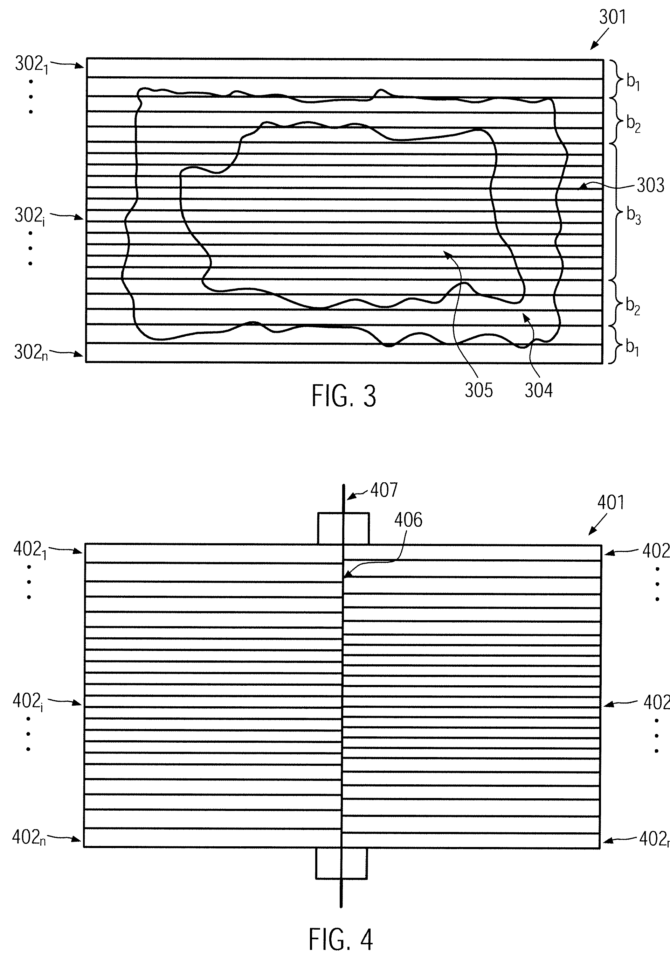

Figur 3 zeigt ein erfindungsgemäßes Photovoltaik-Modul 301 gemäß einer ersten Ausführungsform. Der Aufbau des Photovoltaik-Moduls 301 kann folgendermaßen ausgebildet sein. Zunächst umfasst das Photovoltaik-Modul ein erstes lichtdurchlässiges Substrat, normalerweise aus Glas. Dieses Element wird auch als Frontglas bezeichnet, da es im Betrieb der Lichtquelle, beispielsweise der Sonne, zugewandt ist und Licht über dieses Element in das Photovoltaik-Modul einfällt.

Auf dem Substrat befindet sich eine transparente erste leitfähige Schicht (auch TCO (Transparent Conductive Oxide) - Schicht genannt), beispielsweise aus einem Metalloxid wie fluordotiertem Zinnoxid, bor-, aluminium- oder galliumdotiertem Zinnoxid sowie Indiumzinnoxid. Hierüber wird der generierte Strom auf der der Sonne zugewandten Seite abgeführt. Auf die erste transparente leitfähige Schicht oder Frontkontaktschicht folgt wenigstens eine aktive Schicht oder Absorberschicht, beispielsweise eine Siliziumschicht oder eine CdTe (Cadmiumtellurid)-Schicht oder eine CiGSSe (Cu

$(In,Ga)(S,Se)_2$)-Schicht oder aber eine Tandemzelle aus einer mikrokristallinen und einer amorphen Siliziumschicht. In dieser Schicht wird das einfallende Licht in Strom umgewandelt. Auf der zweiten Seite der aktiven Schicht ist meist eine zweite leitende Schicht, insbesondere eine zweite lichtdurchlässige Schicht, angeordnet, welche üblicherweise aus dem gleichen Material wie die oben beschriebene erste leitende Schicht besteht. Diese Schichten werden üblicherweise durch ein CVD (chemische Gasphasenabscheidung), PECVD (plasmaunterstützte chemische Gasphasenabscheidung) oder PVD (physikalische Gasphasenabscheidung) Verfahren hergestellt.

Auf die zweite leitende Schicht oder Rückkontaktschicht kann außerdem eine Metallschicht oder eine weiße Farbe folgen, um noch nicht in der aktiven Schicht absorbiertes Licht dieser wieder zuzuführen. Über eine Kunststofffolie, beispielsweise aus PVB (Polyvinylbutyral), kann die Struktur mit einem zweiten Substrat, bevorzugt aus Glas (auch Rückglas genannt), verbunden werden.

Die einzelnen über die Oberfläche des Moduls angeordneten Zellen werden bei der Herstellung beispielsweise durch Laser Scribing hergestellt und führen zu einer monolithischen Verschaltung der einzelnen Zellen.

Es hat sich gezeigt, dass es bei der Herstellung der unterschiedlichen Schichten, aus denen das Photovoltaik-Modul zusammengesetzt ist, zu über die Oberfläche des Moduls verteilten Inhomogenitäten in Schichteigenschaften, beispielsweise der Schichtdicke der Absorberschicht, der Leitfähigkeit der Kontaktschichten, der Dotierung der Frontkontaktschicht, der Kristallinität der Absorberschicht und/oder des Haze Parameters der Frontkontaktschicht, kommen kann. Diese über die Fläche des Moduls auftretenden Inhomogenitäten können zu unterschiedlichen Strömen in den betroffenen Bereichen führen. Da in einer Reihenschaltung von Zellen, die Zelle mit dem geringsten Strom den Strom für alle Zellen bestimmt, kommt es zu einer Verschlechterung der Ausbeute des Moduls.

In Figur 2 sind solche lateralen Inhomogenitäten schematisch dargestellt. Dargestellt sind drei Bereiche 203, 204, 205 eines Photovoltaik-Moduls, welche beispielsweise drei unterschiedliche Kurzschlussstromdichten repräsentieren. In diesem Beispiel ist die Kurzschlussstromdichte im Bereich 203 kleiner als in den Bereichen 204 und 205 und die Kurzschlussstromdichte im Bereich 204 ist kleiner als die Kurzschlussstromdichte im Bereich 205 jedoch größer als die Kurzschlussstromdichte im Bereich 203.

Um solchen Inhomogenitäten, wie in Figur 2 gezeigt, Rechnung zu tragen, werden entsprechend der Erfindung, Zellen mit angepassten Zellflächen bereitgestellt. In dieser Ausführungsform sind die Zellen im Wesentlichen rechteckig ausgebildet und haben alle die gleiche Länge 1 aber angepasste unterschiedliche Zellbreiten, hier b1, b2 und b3. Zellen 302i, welche überwiegend in Bereichen niedriger Kurzschlussstromdichten angeordnet sind, in diesem Beispiel dem Randbereich 303, haben dabei eine größere Breite b1 und damit eine größere Fläche als Zellen 302i, welche überwiegend im zentralen Bereich 305 mit höherer Kurzschlussstromdichte angeordnet sind und eine Breite b3 aufweisen.

Durch Anpassung der Fläche der Zellen, insbesondere der Breite der Zellen, eines Photovoltaik-Moduls kann erreicht werden, dass jede Zelle des Moduls im Wesentlichen den gleichen Strom liefert, wobei sich die Stromstärken der einzelnen Zellen um weniger als 5%, insbesondere weniger als 1%, bevorzugt weniger als 0,2%, unterscheiden.

Anstatt der in Figur 3 dargestellten geradlinigen Begrenzungslinien zwischen zwei Zellen, könnten zur weiteren Optimierung auch krummlinige Begrenzungslinien zum Einsatz kommen.

Figur 4 zeigt ein Photovoltaik-Modul 401 gemäß einer zweiten Ausführungsform. Im Gegensatz zum in Figur 3 gezeigten Photovoltaik-Modul, umfasst dieses Photovoltaik-Modul zwei entlang einer ersten Richtung 406 voneinander isolierte Bereiche, die über ein Kontaktelement 407 parallel miteinander verschaltet sind. Jeder der Bereiche umfasst mehrere in Reihe geschaltete Zellen 402i, wobei insbesondere die Anzahl der Zellen 402i im ersten Bereich gleich der Anzahl der Zellen 402i im zweiten Bereich ist. Um die Inhomogenitäten in jedem einzelnen Bereich optimiert berücksichtigen zu können, sind die Flächen der Zellen 402i eines Bereiches unabhängig von den Flächen der Zellen 402i des anderen Bereichs angepasst. Dies wird in Figur 4 dadurch angedeutet, dass in der ersten Richtung 406 die Zellen beider Bereich jeweils individuell optimiert wurden.

Mit anderen Worten weist wenigstens eine Zelle 402i des ersten Bereiches in der ersten Richtung 406 eine von wenigstens einer Zelle 402i des zweiten Bereiches unterschiedliche Längenausdehnung, also eine unterschiedliche Breite, auf. Dadurch wird es möglich ein Photovoltaik-Modul mit der gewünschten Ausgangsspannung und optimierter Leistung herzustellen.

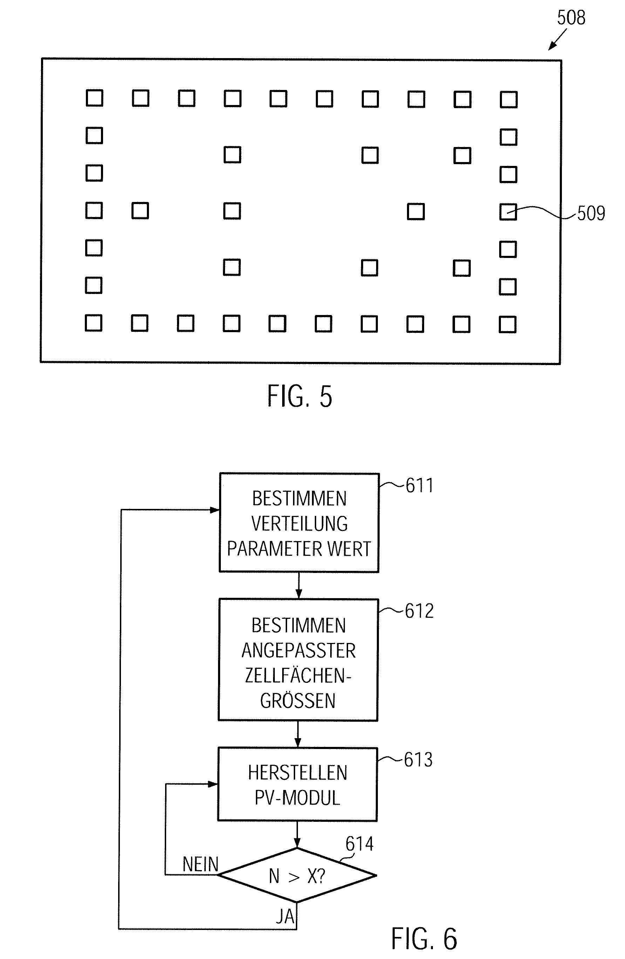

Die in Figur 2 dargestellten Inhomogenitäten können beispielsweise mit Hilfe eines erfindungsgemäßen Testmoduls vermessen werden. Figur 5 zeigt ein solches Testmodul 508, auf welchem mehrere Testzellen 509 verteilt sind. Die Testzellen 509 in dieser Ausführungsform sind voneinander isoliert und somit nicht in Reihe geschaltet wie die Zellen des Photovoltaik-Moduls in Figur 3.

In dieser Ausführungsform sind die Testzellen 509 nicht gleichmäßig über die Oberfläche des Testmoduls 508 verteil. Insbesondere im Randbereich des Testmoduls 508 befinden sich mehr Testzellen 509 als im Zentralbereich. Damit kann der Tatsache Rechnung getragen werden, dass Inhomogenitäten von Schichteigenschaften erfahrungsgemäß vor allem im Randbereich auftreten. Alternativ können die Testzellen 509 eines Testmoduls 508 aber auch gleichmäßig, insbesondere in gleichen Abständen zueinander, angeordnet sein.

Die Testzellen 509 sind in dieser Ausführungsform quadratisch mit einer Seitenlänge von ca. 1 cm. Die Testzellen 509 können aber auch andere Geometrien oder Formen und/oder Größen aufweisen.

Für die einzelnen Testzellen 509 können dann die jeweiligen Kurzschlussstromdichten bestimmt werden. Aus deren individueller Verteilung lässt sich dann für die ganze Fläche des Moduls eine Verteilung dieses Parameters simulieren. Anhand dieser Verteilung kann man dann für jede einzelne Zelle eines Photovoltaik-Moduls eine angepasste Fläche bzw. Breite bestimmen.

Anstatt der Kurzschlussstromdichte, kann jedoch an einem Testsubstrat auch eine Verteilung eines anderen Parameters über die Modulfläche wie Schichtdicke, insbesondere der aktiven Schicht, und/oder Leitfähigkeit, insbesondere der Frontkontaktschicht, und/oder Dotierung, insbesondere der Frontkontaktschicht, und/oder Kristallinität, insbesondere der aktiven Schicht, und/oder des Haze Parameters, insbesondere der Frontkontaktschicht, bestimmt werden. Die Dicke einer Schicht entspricht dabei, insbesondere einer mittleren, Ausdehnung einer Schicht senkrecht zur Zellebene. Je nach Parameter bräuchte man keine individuellen Testzellen bereitstellen, sondern kann mit bekannten Verfahren, wie beispielsweise Ellipsometrie, den gewünschten Parameter bestimmen.

Die genannten Parameter haben alle einen Einfluss auf die Kurzschlussstromdichte, so dass auch aus deren Verteilung über die Fläche des Moduls eine angepasste Zellflächengröße bzw. Zellfächenbreite bestimmt werden kann.

Figur 6 illustriert ein Verfahren zum Herstellen von Photovoltaik-Modulen gemäß der Erfindung. In einem ersten Schritt 611 wird eine Verteilung wenigstens eines Parameterwertes über die Fläche eines Testmoduls, wie in Figur 5 gezeigt, bestimmt.

Das Bestimmen der Verteilung des wenigstens einen Parameterwertes über die Fläche eines Testmoduls kann ein Bestimmen des Parameterwertes in einer oder mehreren, insbesondere in allen, Testzellen des Testmoduls umfassen. In dieser Ausführungsform entspricht der wenigstens eine Parameterwert dem Wert des Kurzschlussstroms der Testzelle.

In Schritt 612 werden angepasste Zellflächengrößen, insbesondere angepasste Zellbreiten, basierend auf der in Schritt 611 bestimmten Verteilung des wenigstens einen Parameterwertes bestimmt. Insbesondere kann für den Bereich, in dem eine Zelle angeordnet werden soll, ein Mittelwert des Parameterwertes, insbesondere durch Mittelung über die in diesem Bereich angeordneten Testzellen, bestimmt werden. Basierend auf diesem Mittelwert wird dann die angepasste Zellflächengröße, insbesondere die angepasste Zellbreite, ermittelt.

Dies kann beispielweise wie folgt geschehen. Auf einem Testmodul, wie beispielsweise in Figur 5 gezeigt, sind M Testzellen verteilt. Nach Messung der Kurzschlussstromdichte der Testzellen wird ein Mittelwert der

Kurzschlussstromdichte $\langle j_{sc} \rangle$ über alle Testzellen ermittelt: $\left\langle j_{sc} \right\rangle = \dfrac{\sum j_{sc}^{l}}{M}$ .

Danach wird für alle N vorgesehenen Zellen eines zu fertigenden Photovoltaik-Moduls eine konstante Anfangsbreite, b, basierend auf der vorherbestimmten Gesamtbreite des Moduls und der vorherbestimmten Anzahl der Zellen, N, bestimmt (siehe, z.B., Figur 1 für ein Photovoltaik-Modul mit Zellen konstanter Breite).

Als nächstes wird die Breite der Zellen derart angepasst, dass jede der N Zellen im Wesentlichen den gleichen Strom liefert.

Dazu wird für jede der N Zellen der Mittelwert der Kurzschlussstromdichte $\langle j_{sc}^{N} \rangle$ für die Zelle bestimmt. Dies geschieht durch Mittelung über alle U Testzellen, die in einem Bereich des Testmoduls angeordnet sind, der dem Bereich der Zelle am Photovoltaik-Modul

entspricht, also: $\left\langle j_{sc}^{N} \right\rangle = \dfrac{\sum j_{sc}^{u}}{U}$ . .

Die Breite einer ersten Zelle 1 wird dann gemäß $b^{1} = b^{1} + \Delta b^{1}$ verändert, beispielsweise vergrößert, wobei

$$\Delta b^{1} = b^{1} \left( \dfrac{\langle j_{sc} \rangle}{\langle j_{sc}^{1} \rangle} - 1 \right) . .$$

Um die Anzahl der Zellen für das Photovoltaik-Modul konstant zu halten, werden danach die Zellbreiten der übrigen Zellen gegenläufig verändert, hier also verkleinert, beispielsweise um $\Delta b = \dfrac{\left(\Delta b^{1}\right)}{\left(N - 1\right)}$ . . Dieser Vorgang kann iterativ für weitere, insbesondere die N-1 weiteren, Zellen wiederholt werden, so dass die von den einzelnen Zellen gelieferten Stromstärken möglichst angeglichen sind.

Das Bestimmen der angepassten Zellflächengrößen, insbesondere angepassten Zellbreiten, kann daher für alle für das Photovoltaik-Modul vorgesehenen Zellen durchgeführt werden, oder auch nur für Zellen, die in einem oder mehreren vorherbestimmten Bereichen angeordnet werden sollen, beispielsweise am Rand.

In diesem Beispiel wird die mittlere Kurzschlussstromdichte bestimmt und die Breite entsprechend der mittleren Kurzschlussstromdichte angepasst. Insbesondere, je kleiner die mittlere Kurzschlussstromdichte umso größer wird die Fläche, insbesondere die Breite, der Zelle gewählt. Beispielsweise kann eine erste Zelle, die eine um 10% niedrigere mittlere Kurzschlussstromdichte aufweist als eine zweite Zelle, eine um 10% größere Fläche aufproportionalen Zusammenhang der Zellflächengröße zur mittleren Kurzschlussstromdichte beruhen.

In Schritt 613 wird dann ein Photovoltaik-Modul mit den angepassten Zellflächengrößen hergestellt. Dazu werden eine oder mehrere Schichten auf einem Substrat, beispielsweise aus Glas, abgeschieden. Insbesondere kann eine Front- und Rückkontaktschicht und wenigstens eine zwischen Front- und Rückkontaktschicht angeordnete Absorberschicht vorgesehen werden, wobei insbesondere die wenigstens eine Absorberschicht eine amorphe und/oder eine mikrokristalline Siliziumschicht aufweist. Die zur monolithischen Verschaltung benötigten Strukturierungsschritte werden üblicherweise durch Laserablation durchgeführt. Alternativ kann das Unterteilen auch durch Scribing (mechanisches Ritzen) oder Lithographie erfolgen. Der oder die Strukturierungsschritte werden dann so durchgeführt, dass die einzelnen Zellen die im Schritt 612 bestimmte Zellflächengröße, insbesondere Zellbreite, aufweisen.

In Schritt 614 wird überprüft, ob die Anzahl der hergestellten Photovoltaik-Module, N, eine vorherbestimmte Anzahl, X, überschreitet. Die vorherbestimmte Anzahl kann hier im Bereich X=100 bis X=1000, insbesondere im Bereich X=300 bis X=800, liegen

Ist die Anzahl nicht größer als die vorherbestimmte Anzahl, wird erneut Schritt 613 durchgeführt und ein weiteres Photovoltaik-Modul mit gleicher Zellflächengrößenverteilung hergestellt. Ist die vorherbestimmte Anzahl X der hergestellten Photovoltaik-Modul überschritten, kehrt das Verfahren zu Schritt 611 zurück und es wird erneut eine Verteilung wenigstens eines Parameterwertes über die Fläche eines neuen Testmoduls ermittelt. Dadurch kann einer eventuellen Änderung der Verteilung des wenigstens einen Parameterwertes, beispielsweise durch Änderungen von Prozessparametern oder einem Drift in den Anlagen, Rechnung getragen werden.

Alternativ oder zusätzlich kann in Schritt 614 auch überprüft werden, ob ein oder mehrere Prozessparameter verändert wurden, beispielsweise zum Herstellen eines unterschiedlichen oder geänderten Photovoltaik-Moduls. Im Falle einer solchen Änderung kann zu Schritt 611 zurückgekehrt werden, andernfalls wird Schritt 613 durchgeführt.

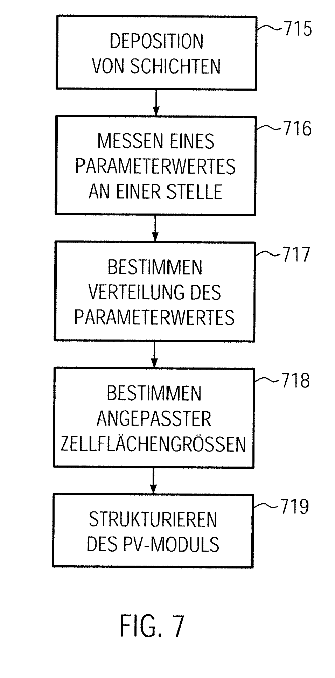

Ein alternatives erfindungsgemäßes Verfahren zum Herstellen von Photovoltaik-Modulen gemäß der Erfindung ist in Figur 7 illustriert.

Darin werden in einem ersten Schritt 715 die einzelnen Schichten des Photovoltaik-Moduls auf einem Substrat abgeschieden, beispielsweise mittels eines CVD Verfahrens. Dadurch erhält das Photovoltaik-Modul seinen prinzipiellen Schichtaufbau.

In einem nächsten Verfahrensschritt 716 wird an einer, insbesondere nur einer, Stelle des Photovoltaik-Moduls ein Parameterwert, beispielsweise die Schichtdicke der Absorberschicht, gemessen. Diese Stelle kann beispielsweise in einem Randbereich des Photovoltaik-Moduls angeordnet sein, wie beispielsweise durch den Bereich 303 in Figur 3 illustriert.

In Schritt 717 wird die Verteilung des Parameterwertes über die Fläche des Photovoltaik-Moduls basierend auf der Messung des Schrittes 716 und einem bekannten, empirischen oder theoretischen Zusammenhang zwischen dem Parameterwert an der einen Stelle und der Verteilung des Parameterwertes über die Fläche des Photovoltaik-Moduls bestimmt.

Auf Basis dieser in Schritt 717 bestimmten Verteilung des Parameterwertes über die Fläche des Photovoltaik-Moduls werden in Schritt 718 die angepassten Zellflächengrößen, insbesondere die angepassten Zellbreiten, der für das Photovoltaik-Modul vorgesehenen Zellen, wie oben beschrieben, bestimmt.

Danach wird das Photovoltaik-Modul in Schritt 719 in Zellen unterteilt, also strukturiert, sodass die Zellen die in Schritt 718 bestimmten angepassten Zellflächengrößen, insbesondere angepassten Zellbreiten, aufweisen. Das Strukturieren wird hier mit Hilfe eines Laserablationsverfahrens durchgeführt.

Das in Figur 7 illustrierte Verfahren erlaubt es, die angepassten Zellflächengrößen, insbesondere die angepassten Zellbreiten, im Herstellungsprozess auch ohne Verwendung eines eigenen Testmoduls zu bestimmen.

Es versteht sich, dass in den zuvor beschriebenen Ausführungsbeispielen genannte Merkmale nicht auf diese speziellen Kombinationen beschränkt und auch in beliebigen anderen Kombinationen möglich sind.

**Patentansprüche**

1. Photovoltaik-Modul (201; 301; 401), insbesondere Dünnschicht Photovoltaik-Modul, umfassend mehrere in Reihe geschaltete Zellen (302i; 402i), wobei wenigstens zwei der Zellen (302i; 402i) voneinander unterschiedlich große Flächen aufweisen.

2. Photovoltaik-Modul (201; 301; 401) nach Anspruch 1, wobei die wenigstens zwei Zellen (302i; 402i), insbesondere die Fläche der wenigstens zwei Zellen (302i; 402i), im Wesentlichen rechteckig ausgebildet sind, und die wenigstens zwei Zellen (302i; 402i) die gleiche Länge (l) aber voneinander unterschiedliche Breiten (b1; b2; b3) aufweisen.

3. Photovoltaik-Modul (201; 301; 401) nach Anspruch 1 oder 2, wobei die Größe der Fläche, insbesondere die Breite (b1; b2; b3), der wenigstens zwei Zellen (302i; 402i) so angepasst ist, dass die wenigstens zwei Zellen (302i; 402i) im Wesentlichen die gleiche Stromstärke oder zumindest eine um nicht mehr als 5%, insbesondere nicht mehr als 1 %, bevorzugt nicht mehr als 0,2%, variierende Stromstärke liefern.

4. Photovoltaik-Modul (201; 301; 401) nach einem der vorangegangenen Ansprüche, wobei die Größe der Fläche, insbesondere die Breite (b1; b2; b3), aller in Reihe geschalteter Zellen (302i; 402i) so angepasst ist, dass alle in Reihe geschaltete Zellen (302i; 402i) im Wesentlichen die gleiche Stromstärke oder zumindest eine um nicht mehr als 5%, insbesondere nicht mehr als 1%, bevorzugt nicht mehr als 0,2%, variierende Stromstärke, liefern.

5. Photovoltaik-Modul (201; 301; 401) nach einem der vorangegangenen Ansprüche, wobei die Größe der Fläche, insbesondere die Breite (b1; b2; b3), der wenigstens zwei Zellen (302i; 402i) basierend auf wenigstens einem Parameterwert der Zelle (302i; 402i) angepasst ist.

6. Photovoltaik-Modul (201; 301; 401) nach Anspruch 5, wobei der wenigstens eine Parameter einer Kurzschlussstromdichte und/oder einer Schichtdicke, insbesondere einer aktiven Schicht, und/oder einer Leitfähigkeit, insbesondere einer Frontkontaktschicht, und/oder einer Dotierung, insbesondere einer Frontkontaktschicht, und/oder einer Kristallinität, insbesondere einer aktiven Schicht, und/oder einem Haze Parameter, insbesondere einer Frontkontaktschicht, entspricht.

7. Photovoltaik-Modul (201; 301; 401) nach einem der vorangegangenen Ansprüche, wobei die Größe der Fläche, insbesondere die Breite (b1; b2; b3), aller in Reihe geschalteter Zellen (302i; 402i) basierend auf wenigstens einem Parameterwert der jeweiligen Zelle (302i; 402i) angepasst ist, wobei insbesondere der wenigstens eine Parameter einer Kurzschlussstromdichte und/oder einer Schichtdicke, insbesondere einer aktiven Schicht, und/oder einer Leitfähigkeit, insbesondere einer Frontkontaktschicht, und/oder einer Dotierung, insbesondere einer Frontkontaktschicht, und/oder einer Kristallinität, insbesondere einer aktiven Schicht, und/oder einem Haze Parameter, insbesondere einer Frontkontaktschicht, entspricht.

8. Photovoltaik-Modul (201; 301; 401) nach einem der vorangegangenen Ansprüche, wobei die in Reihe geschalteten Zellen (302i; 402i) eine oder mehrere zwischen einer Front- und Rückkontaktschicht angeordnete Absorberschichten oder aktive Schichten aufweisen, die insbesondere eine oder mehrere Teilschichten umfassen, wobei insbesondere eine Teilschicht amorphes und/oder mikrokristallines Silizium und/oder $Si_xGe_{1-x}$ (Siliziumgermanium) und/oder $Si_xC_{1-x}$ (Siliziumcarbid) umfasst, wobei x im Bereich 0 bis 1 liegt.

9. Photovoltaik-Modul (201; 301; 401) nach einem der vorangegangenen Ansprüche, wobei das Photovoltaik-Modul (201; 301; 401) wenigstens zwei entlang einer ersten Richtung (406) voneinander isolierte Bereiche aufweist, die parallel verschaltet sind, wobei die wenigstens zwei parallel verschalteten Bereiche mehrere in Reihe geschaltete Zellen (302i;

402i) aufweisen, und wobei wenigstens eine Zelle (302i; 402i) eines Bereiches in der ersten Richtung (406) eine von wenigstens einer Zelle (302i; 402i) eines anderen Bereiches unterschiedliche Längenausdehnung aufweist.

**10.** Verfahren zum Herstellen von Photovoltaik-Modulen (201; 301; 401) mit mehreren in Reihe geschalteten Zellen (302i; 402i), insbesondere von Photovoltaik-Modulen (201; 301; 401) nach einem der vorangegangenen Ansprüche, umfassend die Schritte:

a) Bestimmen einer Verteilung wenigstens eines Parameterwertes über die Fläche eines Testmoduls (508);
b) Bestimmen angepasster Zellflächengrößen, insbesondere angepasster Zellbreiten (b1; b2; b3), basierend auf der Verteilung des wenigstens einen Parameterwertes über die Fläche des Testmoduls (508); und
c) Herstellen wenigstens eines Photovoltaik-Moduls (201; 301; 401) mit Zellen (302i; 402i) mit der angepassten Zellflächengröße, insbesondere angepasster Zellbreite (b1; b2; b3).

**11.** Verfahren nach Anspruch 10, wobei die Schritte a) und b) nach einer vorherbestimmten Anzahl von in Schritt c) hergestellten Photovoltaik-Modulen (201; 301; 401) wiederholt werden.

**12.** Verfahren nach Anspruch 10 oder 11, wobei der wenigstens eine Parameter einer Kurzschlussstromdichte und/oder einer Schichtdicke, insbesondere einer aktiven Schicht, und/oder einer Leitfähigkeit, insbesondere einer Frontkontaktschicht, und/oder einer Dotierung, insbesondere einer Frontkontaktschicht, und/oder einer Kristallinität, insbesondere einer aktiven Schicht, und/oder einem Haze Parameter, insbesondere einer Frontkontaktschicht, entspricht.

**13.** Verfahren nach einem der Ansprüche 10 bis 12, wobei das Testmodul (508) über dessen Fläche verteilt eine Vielzahl von individuellen Testzellen (509) aufweist.

**14.** Verfahren nach Anspruch 13, wobei die individuellen Testzellen (509) regelmäßig, insbesondere in gleichen Abständen, über die Fläche des Testmoduls (508) verteilt sind.

**15.** Verfahren nach Anspruch 13, wobei die individuellen Testzellen (509) inhomogen über die Fläche des Testmoduls (508) verteilt sind, insbesondere wobei ein Randbereich des Testmoduls (508) eine höhere Anzahl an Testzellen (509) aufweist als ein innerer Bereich des Testmoduls (508).

**16.** Verfahren zum Herstellen von Photovoltaik-Modulen (201; 301; 401) mit mehreren in Reihe geschalteten Zellen (302i; 402i), insbesondere von Photovoltaik-Modulen (201; 301; 401) nach einem der Ansprüche 1 - 9, umfassend:

Herstellen wenigstens eines Photovoltaik-Moduls (201; 301; 401 mit Zellen (302i; 402i) mit angepasster Zellflächengröße, insbesondere angepasster Zellbreite (b1; b2; b3), mit den Schritten:

- Bestimmen einer Verteilung wenigstens eines Parameterwertes über die Fläche des wenigstens einen Photovoltaik-Moduls (201; 301; 401) basierend auf einer Messung des wenigstens einen Parameterwertes an wenigstens einer Stelle des wenigstens einen Photovoltaik-Moduls (201; 301; 401); und
- Bestimmen angepasster Zellflächengrößen, insbesondere angepasster Zellbreiten (b1; b2; b3), basierend auf der Verteilung des wenigstens einen Parameterwertes über die Fläche des wenigstens einen Photovoltaik-Moduls (201; 301; 401).

**17.** Verfahren nach Anspruch 16, wobei das Bestimmen einer Verteilung wenigstens eines Parameterwertes und das Bestimmen angepasster Zellflächengrößen vor einem Strukturieren oder Unterteilen des wenigstens einen Photovoltaik-Moduls (201; 301; 401) in mehrere in Reihe geschaltete Zellen (302i; 402i) aber nach der Bildung aller Schichten des wenigstens einen Photovoltaik-Moduls (201; 301; 401) erfolgen.

**18.** Verfahren nach Anspruch 16 oder 17, wobei das Bestimmen einer Verteilung wenigstens eines Parameterwertes ein Messen des wenigstens einen Parameterwertes an wenigstens einer, insbesondere nur einer, Stelle des Photovoltaik-Moduls (201; 301; 401) und ein Bestimmen der Verteilung des wenigstens einen Parameterwertes über die Fläche des wenigstens einen Photovoltaik-Moduls (201; 301; 401) basierend auf der Messung mittels Simulation oder Extrapolation umfasst.

**19.** Verfahren nach einem der Ansprüche 16 bis 18, wobei ein bekannter, insbesondere empirischer oder theoretischer, Zusammenhang zwischen dem wenigstens einen Parameterwert an der wenigstens einen Stelle des wenigstens einen Photovoltaik-Moduls (201; 301; 401) und der Verteilung des wenigstens einen Parameterwertes über die Fläche des wenigstens einen Photovoltaik-Moduls (201; 301; 401) besteht, und wobei die Verteilung des wenigstens einen Parameterwertes über die Fläche des wenigstens einen Photovoltaik-Moduls (201; 301; 401) basierend auf dem bekannten, insbesondere empirischen oder theoretischen, Zusammenhang und der Messung des wenigstens einen Parameterwert an der wenigstens einen Stelle des wenigstens einen Photovoltaik-Moduls (201; 301; 401) bestimmt wird.

20. Testmodul (508), insbesondere zum Verwenden in einem Verfahren nach einem der Ansprüche 10 bis 15, wobei das Testmodul (508) über dessen Fläche verteilt eine Vielzahl von individuellen Testzellen (509) aufweist.

FIG. 1

FIG. 2

$302_1$

$302_i$

$302_n$

$301$

$b_1$

$b_2$

$303$

$b_3$

$b_2$

$b_1$

**FIG. 3**

$305$   $304$

$407$

$406$

$401$

$402_1$

$402$

$402_i$

$402$

$402_n$

$402_r$

**FIG. 4**

508

509

FIG. 5

611

BESTIMMEN
VERTEILUNG
PARAMETER WERT

612

BESTIMMEN
ANGEPASSTER
ZELLFÄCHEN-
GRÖSSEN

613

HERSTELLEN
PV-MODUL

614

NEIN

N > X?

JA

FIG. 6

DEPOSITION
VON SCHICHTEN
~715

↓

MESSEN EINES
PARAMETERWERTES
AN EINER STELLE
~716

↓

BESTIMMEN
VERTEILUNG DES
PARAMETERWERTES
~717

↓

BESTIMMEN
ANGEPASSTER
ZELLFLÄCHENGRÖSSEN
~718

↓

STRUKTURIEREN
DES PV-MODULS
~719

FIG. 7

**Europäisches Patentamt**
**European Patent Office**
**Office européen des brevets**

# EUROPÄISCHER RECHERCHENBERICHT

Nummer der Anmeldung

EP 09 17 2782

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2008/083448 A1 (BORDEN PETER G [US]) 10. April 2008 (2008-04-10) * Abbildungen 2,3 * * Absätze [0062] - [0064], [0067] * ----- | 1-20 | INV. H01L27/142 H01L31/042 |
| X | US 2008/121264 A1 (CHEN CHI-LIN [TW] ET AL) 29. Mai 2008 (2008-05-29) * Abbildungen 1A, 2, 3 und zugehöriger Text * ----- | 1-14,16, 18-20 | |
| X | JP 62 066684 A (SANYO ELECTRIC CO) 26. März 1987 (1987-03-26) * das ganze Dokument * ----- | 1-12, 16-20 | |
| X | US 2008/216886 A1 (IWAKURA TADASHI [JP]) 11. September 2008 (2008-09-11) * das ganze Dokument * ----- | 1-20 | |

RECHERCHIERTE SACHGEBIETE (IPC)

H01L

Der vorliegende Recherchenbericht wurde für alle Patentansprüche erstellt

| Recherchenort | Abschlußdatum der Recherche | Prüfer |
|---|---|---|
| München | 24. Februar 2010 | Moehl, Sebastian |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

**ANHANG ZUM EUROPÄISCHEN RECHERCHENBERICHT
ÜBER DIE EUROPÄISCHE PATENTANMELDUNG NR.**

EP 09 17 2782

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

24-02-2010

| Im Recherchenbericht angeführtes Patentdokument | Datum der Veröffentlichung | Mitglied(er) der Patentfamilie | Datum der Veröffentlichung |
|---|---|---|---|
| US 2008083448 A1 | 10-04-2008 | DE 112007002316 T5<br>WO 2008042682 A2 | 26-11-2009<br>10-04-2008 |
| US 2008121264 A1 | 29-05-2008 | CN 101192617 A | 04-06-2008 |
| JP 62066684 A | 26-03-1987 | JP 1818941 C<br>JP 5028513 B | 27-01-1994<br>26-04-1993 |
| US 2008216886 A1 | 11-09-2008 | CN 101213673 A<br>DE 112006001752 T5<br>JP 2007012976 A<br>WO 2007004501 A1 | 02-07-2008<br>29-05-2008<br>18-01-2007<br>11-01-2007 |

EPO FORM P0461

Für nähere Einzelheiten zu diesem Anhang : siehe Amtsblatt des Europäischen Patentamts, Nr.12/82